Europäisches Patentamt

European Patent Office

Office européen des brevets

(19)

(11) **EP 1 274 170 A1**

(12) **DEMANDE DE BREVET EUROPEEN**

(43) Date de publication:
**08.01.2003 Bulletin 2003/02**

(51) Int Cl.⁷: **H03H 17/06**

(21) Numéro de dépôt: **02368067.1**

(22) Date de dépôt: **28.06.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **29.06.2001 FR 0108693**

(71) Demandeur: **STMicroelectronics S.A.**
**92120 Montrouge (FR)**

(72) Inventeurs:
• **Petit, Eric**
**38400 Saint Martin d'Hères (FR)**
• **Lenez, Thierry**
**38000 Grenoble (FR)**

(74) Mandataire: **Schuffenecker, Thierry**
**97, chemin de Cassiopée,**
**Domaine de l'étoile**
**06610 La Gaude (FR)**

(54) **Dispositif de conversion d'une séquence d'échantillons numériques**

(57) Dispositif de conversion automatique d'une séquence d'échantillons numérique X(n) arrivant à une première cadence $f_e$, et convertie en une séquence d'échantillons numérique Y(m) sortant à une seconde cadence $f_s$ inférieure à $f_e$. Un ensemble interpolateur-décimateur présentant un taux de décimation égal à γ choisi de manière à correspondre au décalage de fréquence $f_e/f_s$ est basé sur un filtre polyphasé présentant p tables de q éléments chacun, ledit filtre étant conçu de manière à ce que les échantillons X(n) rentrent à la cadence $f_e$ et de manière à ce que les éléments des tables sont activées au rythme d'une seconde horloge dérivée de l'horloge $f_e$, et dont l'un des pulses est manquant.

Fig.4

## Description

### Domaine technique de l'invention

La présente invention concerne le domaine des communication numériques et plus spécialement un procédé de conversion d'échantillons numériques.

### Etat de la technique

Le secteur des communications numériques est en développement constant et les vitesses de communication sont en constante augmentation.

Si l'on considère l'architecture d'un système de communication numérique, il est classique de rappeler que le signal numérique - en général une suite de symboles à transmettre - est converti sous la forme d'un signal analogique à temps continu qui est alors transmis par un milieu de propagation physique, de l'air ou tout autre milieu physique de propagation. Lorsque le signal est reçu par le récepteur, il est alors traité et converti sous une forme numérique au moyen d'un échantillonnage approprié, lequel intervient en général à une fréquence $f_e$ que l'on cherche en général à rendre synchrone par rapport à la fréquence $f_s$ à l'émission des symboles. Malheureusement les circuits oscillateurs qui équipent l'émetteur et le récepteur ne sont jamais synchrones et il faut alors compenser toute dérive en fréquence entre les deux horloges d'émission et de réception de manière à pouvoir traiter convenablement le signal reçu et en extraire les symboles émis. La compensation de fréquence à la réception est en général réalisée au moyen d'un circuit oscillateur régulé en tension, connu sous la dénomination *Voltage Controlled Oscillator* chez les anglo-saxons, lequel oscillateur est commandé par un circuit de synchronisation chargé d'estimer la dérive en fréquence qu'il convient de corriger.

Malheureusement un oscillateur commandé en tension et un circuit échantillonneur commandé sont des dispositifs analogiques complexes, peu précis, coûteux à mettre en oeuvre et qui permettent peu de flexibilité pour le traitement du signal. On privilégie aujourd'hui largement un traitement numérique global de l'information en cherchant à réduire, autant que possible, la part des circuits purement analogiques dans les systèmes de transmission.

Il est donc souhaitable de pouvoir s'affranchir de l'oscillateur commandé en tension, voire de l'échantillonneur commandé. On souhaite pouvoir effectuer un échantillonnage libre d'un signal analogique, et de procéder ensuite à la conversion d'échantillons numériques à une autre fréquence.

### Exposé de l'invention

La présente invention a pour but de proposer un dispositif de conversion numérique du rythme d'échantillonnage d'une séquence d'échantillons numériques $X(n)$ arrivant à une cadence $f_e$ et converti en une séquence $Y(m)$ sortant à une cadence $f_s$.

Un autre but de la présente invention consiste à fournir un dispositif d'échantillonnage d'un signal analogique qui ne nécessite pas de circuit oscillant commandé en tension pour réaliser l'échantillonnage commandé.

L'invention réalise ces buts au moyen d'un dispositif de conversion automatique d'une séquence d'échantillons numérique $X(n)$ arrivant à une première cadence $f_e$, et convertie en une séquence d'échantillons numérique $Y(m)$ sortant à une seconde cadence $f_s$ inférieure à $f_e$. Un ensemble interpolateur-décimateur présentant un taux de décimation égal à y choisi de manière à correspondre au décalage de fréquence $f_e/f_s$ est basé sur un filtre polyphasé présentant p tables de q éléments chacun, ledit filtre étant conçu de manière à recevoir des échantillons $X(n)$ présentés à une cadence $f_e$ et dont les composantes polyphasées dudit filtre sont successivement activées au rythme d'une seconde horloge dérivée de l'horloge $f_e$, et dont certains pulses sont manquants.

Préférentiellement, le dispositif comporte une unité de synchronisation pour successivement activer les composantes polyphasées au rythme de la fréquence de sortie $f_s$ et un circuit de sélection (41, 81) de la séquence de sortie $Y(m)$ du filtre de manière à ne retenir que la séquence correcte des échantillons correspondant à une interpolation-décimation par facteur non entier.

Dans un mode de réalisation, un compteur est utilisé pour générer un signal à chaque passage à une valeur entière de l'opérande $\gamma m \oplus 1$ et servant à commander ledit circuit de sélection de données $Y(m)$.

Dans un mode de réalisation préféré, le dispositif utilise un interpolateur décimateur basé sur un filtre polyphasé, lequel comporte une série de $p=2N+1$ tables présentant chacune un jeu de q coefficients utilisés pour calculer une convolution entre un filtre d'interpolation et de décimation et un vecteur $X(n)$ correspondant à la séquence des échantillons numériques à l'entrée.

**Description des dessins**

La figure 1 illustre le schéma de principe d'un interpolateur décimateur en cascade permettant d'effectuer de la décimation par facteur non entier.

La figure 2 représente la formule d'interpolation-décimation par facteur non entier de la séquence d'échantillons X(n)

La figure 3 présente un schéma de principe du circuit de conversion de l'instant d'échantillonnage.

La figure 4 montre une vue synoptique du filtre polyphasé et du circuit de génération de l'horloge $f_s$ et de synchronisation des tables du filtre polyphasé.

La figure 5 montre le synoptique du circuit de sélection de l'élément des tables du filtre polyphasé.

La figure 6 montre le synoptique de génération de l'horloge $f_s$ lorsque le taux de décimation $\gamma$ est compris entre 1 et 2.

La figure 7 montre la modification à apporter au circuit de génération d'horloge dans le cas général ou y est supérieur à 2.

La figure 8 montre un mode de réalisation détaillé pour $\gamma = 6/5$ ainsi que des chronogrammes représentatifs des signaux d'horloges générés.

La figure 9 illustre un mode de réalisation détaillé du circuit de génération d'horloge $f_s$ pour $\gamma = 11/5$.

La figure 10 illustre des chronogrammes représentatifs pour le cas $\gamma = 11/5$.

La figure 11 représente un exemple de modélisation en VHDL.

**Description d'un mode de réalisation préféré**

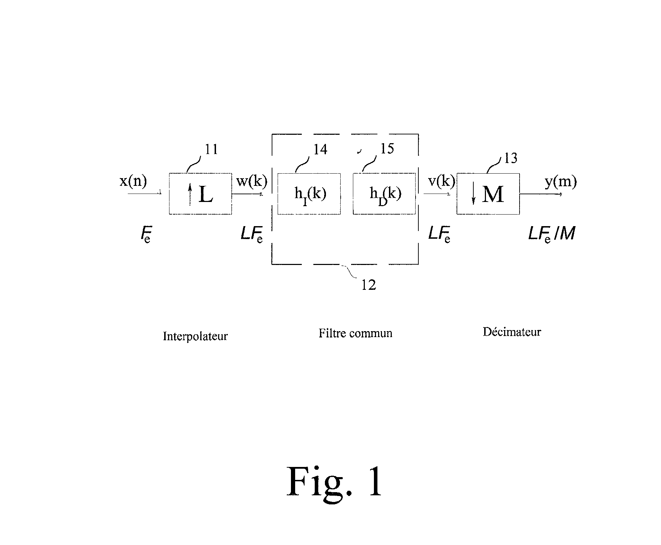

La figure 1 illustre le schéma de principe d'un ensemble interpolateur-décimateur permettant de réalisation une décimation par nombre non entier. Les échantillons X(n) sont fournies à une cadence $f_e$ qui correspond à celle d'un échantillonneur libre dont on aura par exemple fixée la fréquence nominale à une valeur légèrement supérieure à celle de la fréquence utilisée à l'émission par exemple. Dans un autre mode de réalisation on pourra judicieusement fixer la valeur de la fréquence nominale comme étant le double de la valeur de la fréquence à l'émission, ce qui permettra une marge de manoeuvre importante pour la décimation. Dans un autre mode de réalisation, par exemple pour des applications dans les réseaux de transport de type *Very high bit rates Digital Suscriber Line* (V.D.S.L.), on aura pu déjà opportunément introduire un interpolateur à l'émission et un suréchantillonnage correspondant. Un tel échantillonneur peut être introduit pour faciliter la conception des circuits analogiques qui seront nécessaires à la réception synchrone du signal. D'une manière générale, comme on le voit l'homme du métier pourra donc choisir les valeurs nominales des fréquences en fonction de l'application concrète souhaitée pour le récepteur ou pour tout autre dispositif de traitement numérique nécessitant la conversion de fréquence d'échantillonnage. Comme on le verra plus loin, il ne sera pas nécessaire que les valeurs nominales des fréquences coïncident parfaitement puisqu'une correction de la dérive en fréquence sera automatiquement apportée par un traitement numérique adéquat.

On décrit maintenant, en référence à la figure 1, le traitement des éléments X(n) arrivant à la cadence $f_e$. On effectue d'abord un suréchantillonnage par un facteur L - représenté par le bloc fonctionnel 11 - de manière à intercaler L-1 zéros entre deux échantillons consécutifs X(n) et X(n+1). On aboutit ainsi à une nouvelle séquences d'échantillons W(k) Qui, comme on le sait, présente deux spectres images, lesquels sont alors éliminées par un premier filtrage $h_I$(k) effectué par un filtre 14, suivi ensuite par un second filtrage $h_D$(k) représenté par le bloc 15, et destiné à préparer l'opération ultérieure de décimation.

La séquence V(k) produite en sortie du bloc 15 fait ensuite l'objet d'une décimation par facteur M (représenté par l'élément 13) de manière à générer la séquence Y (m) d'échantillons à une fréquence égale à L/M fois la fréquence d'entrée $f_e$. Comme cela a été évoqué précédemment, on choisira le rapport L/M en fonction de l'application particulière qui est souhaitée et on va maintenant décrire une architecture qui permet de produire automatiquement l'effet de conversion ainsi que la génération de l'horloge $f_s$.

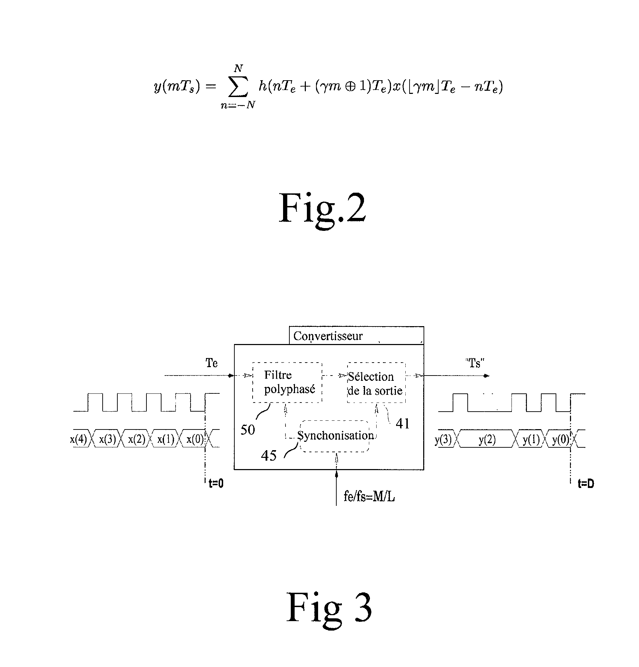

L'effet de l'interpolateur-décimateur représenté en figure 1, incluant les deux filtres 14 et 15 que l'on regroupe sous l'élément générique 12, permet de réaliser un traitement d'interpolation-décimation par facteur non entier conformément à la formule indiquée en figure 2 dans laquelle on voit que l'on réalise une convolution sur 2xN +1 éléments d'un vecteur d'entrée X(n) et d'un filtre H correspondant à la combinaison des éléments 14 et 15 de la figure 1. $T_e$ et $T_s$ correspondent respectivement à l'inverse des fréquence d'entrée $f_e$ et de sortie $f_s$ de l'interpolateur-décimateur. D'une manière générale le choix de 2xN+1 sera lié à la puissance de calcul dont on dispose et à la précision souhaitée pour l'opération de conversiondu rythme symbole. On observera que si l'on souhaite procéder à des ajustements particulièrement fins du facteur de décimation M/L, il faudra dimensionner le calcul de la convolution de manière correspondante.

Si l'on appelle $\gamma$ le facteur de décimation M/L, la formule peut être écrite sous une forme condensée, de la manière suivante :

$$y(m) = \Sigma\ h(n + \gamma m \oplus 1)\ x\ (\llcorner\ \gamma m \lrcorner - n) \tag{1}$$

avec, par convention, les opérateurs $\oplus 1$ et $\llcorner\ \lrcorner$ renvoyant respectivement la partie fractionnée et la partie entière basse de l'opérande.

Si l'on considère par exemple, M=6 et L=5, on arrive à un taux d'interpolation décimation égal à $\gamma$ = M/L= 1.2

Si l'on développe partiellement cette formule autour du point central **N=0** (représenté en gras) on trouve le développement suivant pour m=0 :

$$Y(0) = ..... + h(-2)x(2) + h(-1)x(1) + h(0)x(0) + h(1)x(-1) + h(2)x(-2) + ....$$

Puisque l'on a $\gamma m \oplus 1$ et $\llcorner\ \gamma m \lrcorner$ est égal à 0 (m=0). Si l'on applique à présent la formule à m=1 - conduisant respectivement aux valeurs $\gamma m \oplus 1$ =0.2 et $\llcorner\ \gamma m \lrcorner$ = 1, on a le développement suivant pour Y(1) :

$$Y(1) = ..... + h\ (-2+0.2)x(1+2) + h(-1+0.2)x(1+1) + h(0+0.2)x(1+0) + h(1+0.2)x(1-1) +$$

$$h(2+0.2)x(1-2) + ....$$

$$\text{Soit } Y(1) = ... + h(-2+0.2)x(3) + h(-1+0.2)x(2) + h(0+0.2)x(1) + h(1+0.2)x(0) + h(2+0.2)x(-1)$$

$$+ ...$$

Pour les valeurs successives de m=2, m=3, m=4 on trouve :

$$Y(2) = ... + h(-2+0.4)x(4) + h(-1+0.4)x(3) + h(0+0.4)x(2) + h(1+0.4)x(1) + h(2+0.4)x(0) + ...$$

$$Y(3) = ... + h(-2+0.6)x(5) + h(-1+0.6)x(4) + h(0+0.6)x(3) + h(1+0.6)x(2) + h(2+0.6)x(1) + ...$$

$$Y(4) = ... + h(-2+0.8)x(6) + h(-1+0.8)x(5) + h(0+0.8)x(4) + h(1+0.8)x(3) + h(2+0.8)x(2) + ...$$

Pour m=5, on observe que $\gamma m \oplus 1$ =0 et $\llcorner\ \gamma m \lrcorner$ = 6, ce qui conduit au développement suivant pour Y(5)

$$Y(5) = ... + h(-2+0)x(8) + h(-1+0)x(7) + h(0+0)x(6) + h(1+0)x(5) + h(2+0)x(4) + ...$$

Et pour m=6, on trouve :

$$Y(6) = ... + h(-2+0.2)x(9) + h(-1+0.2)x(8) + h(0+0.2)x(7) + h(1+0.2)x(6) + h(2+0.2)x(5) + ...$$

On observe qu'un décalage s'insinue entre le calcul de Y(4) et celui de Y(5) puisque, pour celui-ci, le cofacteur central de la convolution correspond à x(4) tandis que pour celui-là le cofacteur central correspond à x(6).

D'une manière plus générale on peut faire les deux observations suivantes. En premier lieu, il faut changer continuellement la réponse du filtre à utiliser par le décimateur afin de générer les éléments de sortie Y(m) du circuit de conversion. En outre, bien que changeant continuellement, les coefficients du filtrage H réapparaissent de maniè-re périodique. En second lieu, on observe également un décalage intervenant entre la séquence des X(n) et celle des Y(m), lequel décalage va correspondre à la conversion de cadence introduite entre l'entrée et la sortie de l'interpolateur décimateur.

La figure 3 montre le principe général d'un convertisseur permettant de convertir automatiquement une première séquence d'échantillons X(n) à une première fréquence $f_e$, en une seconde séquence d'échantillons Y(m) à une seconde fréquence $f_s$. On utilise à cet effet un filtre polyphasé 50 recevant en entrée la séquence d'échantillons X(n) à la cadence $f_e$, et comportant des tables de coefficients qui sont rythmées par un système de synchronisation 45 générant la seconde fréquence de sortie $f_s$ des éléments Y(m). Comme le nombre d'éléments en entrée est plus élevé que le nombre des éléments en sortie, un circuit de sélection de sortie 41 sert à produire le juste nombre d'échantillons Y(m).

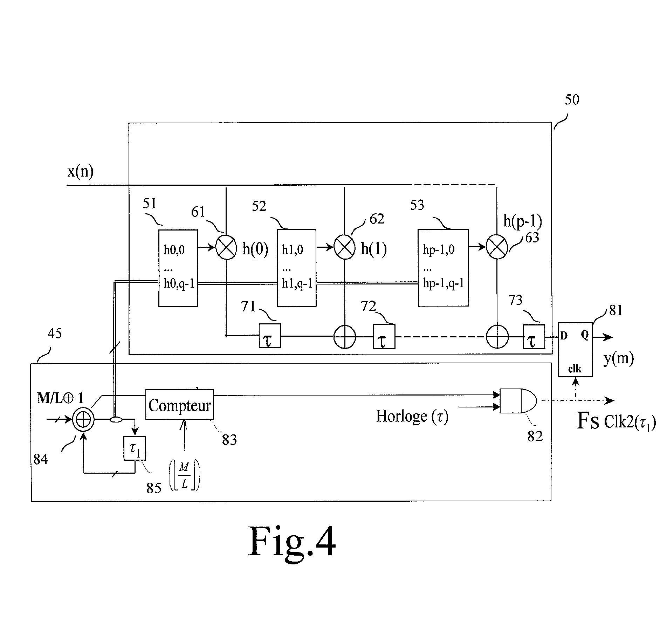

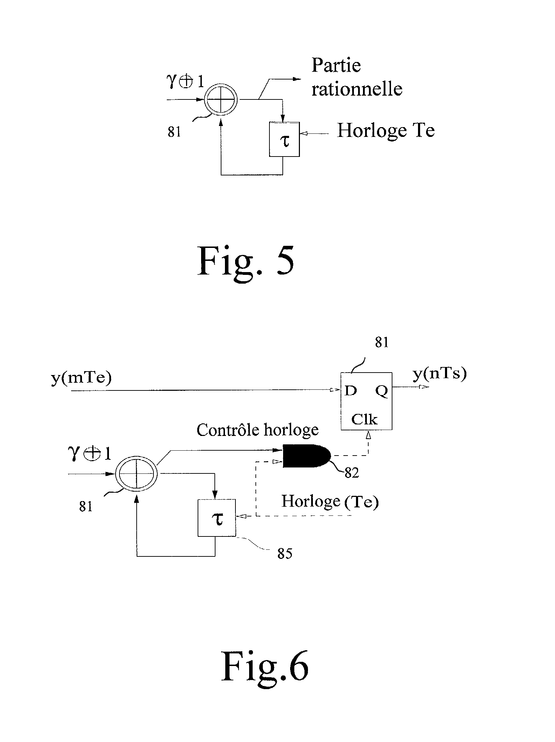

La figure 4 montre une vue détaillée du convertisseur d'échantillonnage. Le filtre polyphasé 50, reçevant les échantillons X(n) en entrée, comporte une série de p tables (p = 2xN+1), chaque table comportant q éléments. Le nombre d'éléments de chacune des tables est choisi en fonction de la précision que l'on souhaite obtenir sur la conversion de fréquence. Pour une conversion de fréquence de 1/100, il convient de noter que le filtre polyphasé devra comprendre des tables comportant pas moins de 100 éléments. La figure 4 ne représente qu'un nombre limitatif de tables, à savoir une table 51 contenant les q éléments h(0,0) à h(0, q-1) intervenant pour le calcul d'un cofacteur donné dans la formule (1). Une table 52 contient q élément additionnels correspondant aux coefficients h(1,0) à h(1, q-1). Une table 53 contient les q coefficients h(2,0) à h(2, q-1). Comme on le voit sur la figure 4 et spécialement la figure 5, la selection des composantes des tables du filtre polyphasé 50 est effectué au moyen d'un additionneur modulo 1 permettant d'activer successivement, à la cadence de l'horloge $f_e$, les différentes composantes des tables du filtre polyphasé 50. Pour compléter la structure du filtre polyphasé on prévoit en outre un ensemble de multiplieurs - tels que par exemple les éléments 61 à 63 représentés sur la figure 4 - ainsi que des éléments de retard $\tau$ (correspondant à la cadence d'entrée des échantillons X(n)) tels que les éléments 71-72 et 73. La structure d'un filtre polyphasée en bien connue d'un homme du métier et ne requiert par conséquent pas de développements supplémentaires. Il suffit d'observer que l'ensemble de la structure permet, à un instant donné, de calculer les cofacteurs élémentaires nécessaire à la convolution entre le filtre H et les échantillons X(n) en entrée.

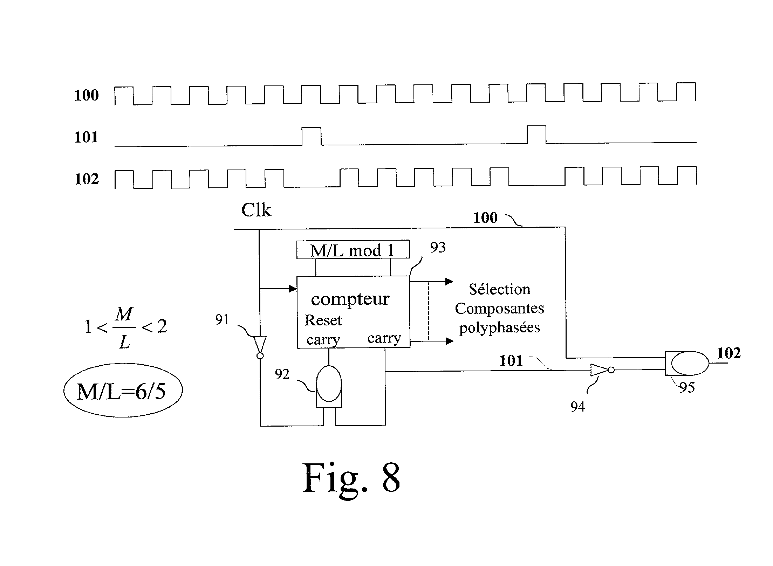

La sélection des données en sortie du filtre polyphasé dépend de la valeur de $\gamma$ qui est considérée. La figure 6 montre un mode de réalisation correspondant à une valeur $\gamma$ comprise entre 1 et 2. On voit que dans ce cas, la sortie du circuit 81 réalisant l'addition modulo 1 peut être directement utilisée pour commander une porte ET 82 dont une seconde entrée reçoit la fréquence d'entrée $f_e$ (= $1/T_e$). On connecte alors la sortie de la porte ET à l'entrée horloge d'une bascule D 81 recevant à son entrée Q la séquence Y(m) en sortie du filtre polyphasé. Comme on le verra plus particulièrement sur les chronogrammes de la figure 8, correspondant au cas particulier $\gamma = 6/5$, la fréquence $f_s$ présente un défaut ou « trou » dans la séquence de pulse qui permet de générer le décalage de fréquence, et surtout, de produire une séquence d'échantillons Y(m) comportant le « décalage » recherché entre Y(4) et Y(5).

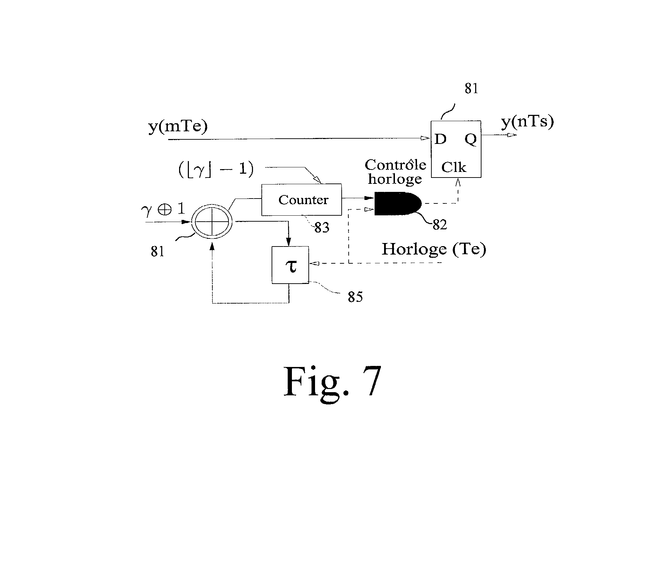

La figure 7 montre un circuit adapté au cas général $\gamma > 1$. Dans ce cas on insère, entre la sortie de l'additionneur 81 modulo 1 et l'entrée de la porte ET 82 une unité de comptage permettant d'effectuer la correction recherchée pour provoquer la suppression d'un pulse de la fréquence $f_e$ à chaque passage à une valeur entière de l'opérande $\llcorner \gamma m. \lrcorner$

Ainsi, l'horloge $f_s$ est donc crée par la suppression d'un pulse élémentaire tous les q pulses d'horloge de $f_e$ et qui coincide avec l'instant du décalage à intervenir entre le rang des échantillons de sortie Y(m) et celui des échantillons d'entrées X(n). En appliquant ce signal d'horloge à l'entrée horloge de la bascule D, cette dernière maintient en sortie la valeur fournit par le calcul précédent et provoque ainsi, au coup suivant, le décalage souhaitée pour l'obtention de la séquence d'échantillons Y(m).

On arrive ainsi, comme on le voit, à obtenir une séquence d'échantillons Y(m) qui, bien qu'étant à chaque instant synchrone avec les échantillons d'entrées X(n), sortent en moyenne à une nouvelle cadence qui est réglable, fonction du taux de décimation y , et dont les valeurs correspondent aux échantillons réels qui auraient été prélevés sur le signal analogique réel si l'on avait procédé à l'échantillonnage à cette seconde cadence .

La figure 8 illustre plus particulièrement un mode de réalisation correspondant à $\gamma = 6/5$. La fréquence d'entrée $f_e$ est transmis par un circuit 100 à une entrée horloge d'un compteur 93 ainsi qu'à l'entrée d'une inverseur 91 dont la sortie est connectée à une première entrée d'une porte ET 92, dont une seconde entrée reçoit le signal de CARRY d'un compteur 93. La sortie de la porte ET 92 est utilisée pour remettre à jour la CARRY du compteur 93 permettant de générer la valeur de l'addition successive des $\gamma \oplus 1$ ou $M/L \oplus 1$. Le compteur 93 peut donc être directement utilisé pour effectuer la sélection des composantes polyphasées du filtre 50. Le signal de CARRY est transmis par un circuit 101 vers un inverseur 94 dont la sortie est connectée à une première entrée d'une porte ET 102 dont la seconde entrée reçoit le signal d'horloge $f_e$ et produit, en sortie, la fréquence $f_s$ désirée sur un circuit 102. La figure 8 illustre plus particulièrement les chronogrammes des signaux d'horloge d'entrée (100), du signal d'horloge de sortie (102) et du signal de CARRY (101).

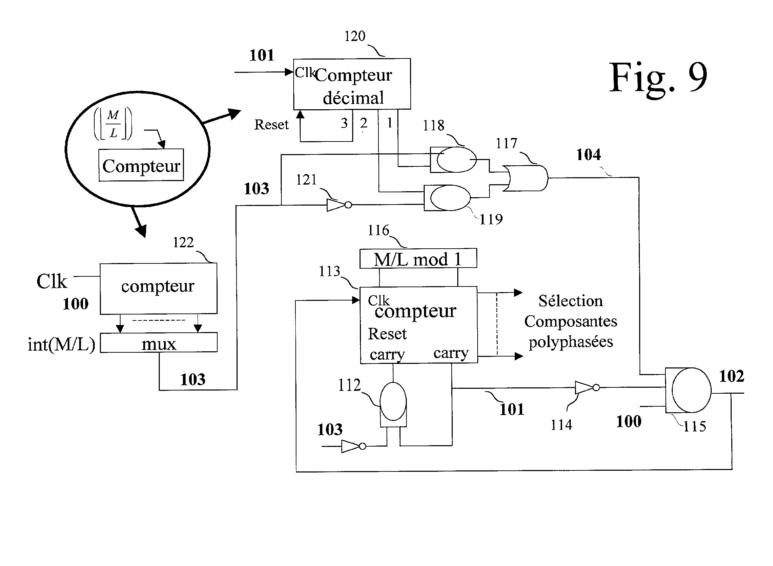

La figure 9 montre la structure modifiée de manière à correspondre au cas $\gamma > 2$. Un compteur 113 permettant la sélection des phases du filtre polyphasé reçoit un signal d'horloge de la sortie 102 d'une porte ET 115 présentant trois entrées. Une première entrée la sortie d'un inverseur 114 dont l'entrée est connectée à la CARRY du compteur 113. Une seconde entrée de la porte ET 115 reçoit le signal d'horloge à la fréquence fe, tandis qu'une troisième entrée reçoit via un circuit 104 le signal de sortie d'une porte OU 117. La mise à zéro de la CARRY du compteur 113 est effectuée au moyen d'une porte ET 112 qui reçoit à une première entrée le signal de CARRY lui-même et, à une seconde entrée, la sortie inversée d'un signal 103 généré par un compteur 122 et correspondant à une division par deux de la fréquence d'entrée $f_e$ existant sur le circuit 100.

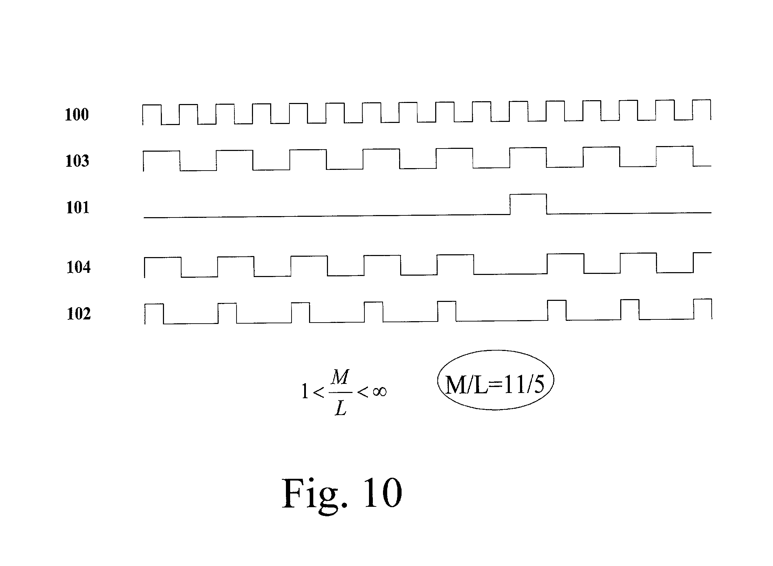

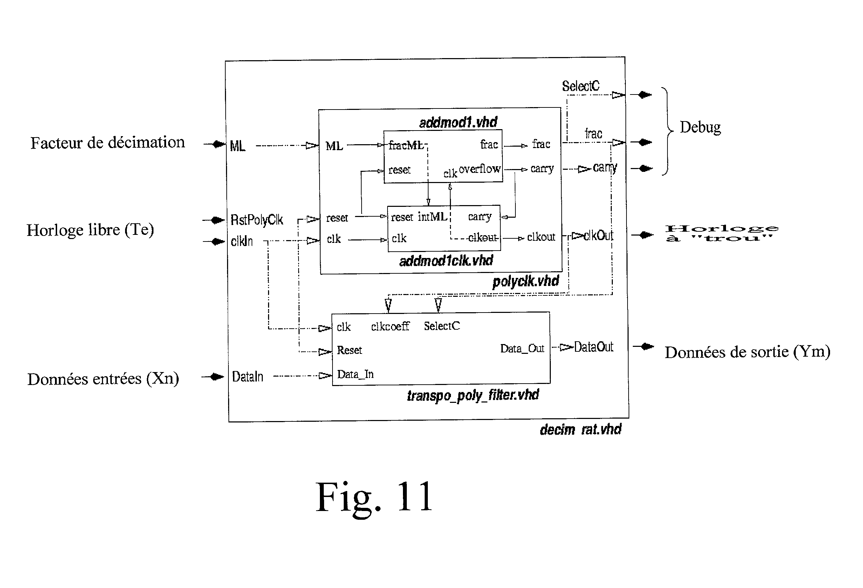

La porte OU 117 possède deux entrées qui sont respectivement connectées à la sortie d'une porte ET 118 et d'une porte ET 119. La porte ET 118 possède une première entrée connectée au circuit 103 et une seconde entrée connectée à la première sortie d'un compteur décimal 120 - monté en diviseur de fréquence- et dont l'entrée horloge reçoit le signal de CARRY sur le circuit 101. La porte ET 119 possède une première entrée qui est connecté via un inverseur au circuit 103 et une seconde entrée qui est connectée à une seconde sortie du compteur dédcimal 120. Le compteur décimal 120 a sa troisième sortie connecté au signal de mise à zéro, assurant ainsi la division de fréquence souhaitée. Les chronogrammes représentatifs des signaux 100-104 sont illustrés dans la figure 10 et la figure 11 illustre plus particulièrement un mode de réalisation qui est directement transposable dans le langage VHDL.

**Revendications**

1.  Dispositif de conversion de fréquence d'échantillonnage comportant

    -   un échantillonneur libre opérant un premier échantillonnage d'un signal analogique à une première fréquence (fe) pour dériver des signaux numériques X(n) ;

    -   un interpolateur décimateur présentant un taux de décimation égal à $\gamma$ basé sur un filtre polyphasé (50) présentant p tables de q éléments chacun, ledit filtre polyphasé étant conçu de manière à ce que les échantillons X(n) rentrent à la cadence de ladite première fréquence $f_e$ et les composantes polyphasées étant successivement activées au rythme d'une seconde fréquence $f_s$ dérivée de ladite première fréquence $f_e$ par la suppression d'un pulse à chaque passage à une valeur entière de l'opérande $\llcorner \gamma m \lrcorner$ de manière à produire une séquences d'échantillons en sortie correspondant à ladite seconde cadence.

2.  Dispositif selon la revendication 1 **caractérisé en ce qu'**il comporte une unité de synchronisation (45) desdites composantes polyphasées et d'un circuit de sélection (41, 81) de la sortie Y(m) du filtre de manière à produire une séquence correcte des échantillons Y(m) cadencée à la bonne fréquence $f_s$.

3.  Dispositif selon la revendication 2 **caractérisé en ce qu'**il comporte un compteur (83) permettant de générer un signal à chaque passage à une valeur entière de l'opérande $\llcorner \gamma m \lrcorner$ et servant à bloquer la transmission de l'horloge d'entrée cadencée à ladite première fréquence $f_e$ et de manière à générer l'horloge de sortie $f_s$ servant à commander ledit circuit de sélection (41, 81).

4.  Dispositif selon la revendication 1 **caractérisé en ce que** ledit filtre polyphasé comporte une série de p=2N+1 tables présentant chacune un jeu de q coefficients utilisés pour calculer une convolution entre un filtre d'interpolation et de décimation et un vecteur X(n) correspondant à la séquence des échantillons numériques à l'entrée, la sélection des composantes polyphasées dudit filtre étant commandée par un additionneur modulo 1 opérant à la fréquence de sortie $f_s$ du convertisseur.

Fig. 1

$$y(mT_s) = \sum_{n=-N}^{N} h(nT_e + (\gamma m \oplus 1)T_e)x(\lfloor \gamma m \rfloor T_e - nT_e)$$

# Fig.2

# Fig 3

Fig.4

$\gamma \oplus 1$

81

Partie
rationnelle

Horloge Te

$\tau$

# Fig. 5

81

y(mTe)

y(nTs)

D    Q

Clk

Contrôle horloge

$\gamma \oplus 1$

81

82

$\tau$

Horloge (Te)

85

# Fig.6

y(mTe)

81

$(\lfloor \gamma \rfloor - 1)$

$\gamma \oplus 1$

81

Counter

83

Contrôle horloge

82

Horloge (Te)

$\tau$

85

D    Q

Clk

y(nTs)

# Fig. 7

100

101

102

Clk

M/L mod 1    93

$$1 < \frac{M}{L} < 2$$

91

compteur

Reset

carry        carry

92

M/L=6/5

100

Sélection
Composantes
polyphasées

101

94

95

102

Fig. 8

Fig. 9

100
103
101
104
102

$$1 < \frac{M}{L} < \infty$$

$(M/L = 11/5)$

Fig. 10

Facteur de décimation → ML

addmod1.vhd

ML → ML → fracML — frac → frac

reset — clk overflow — carry —▷ carry

SelectC

frac

Debug

Horloge libre (Te) → RstPolyClk → reset

clkIn → clk → clk

reset intML carry

clk — clkout → clkout —▷ clkOut → Horloge à "trou"

addmod1clk.vhd

polyclk.vhd

clk clkcoeff SelectC

Reset Data_Out —▷ DataOut → Données de sortie (Ym)

Données entrées (Xn) → DataIn → Data_In

transpo_poly_filter.vhd

decim rat.vhd

Fig. 11

**EP 1 274 170 A1**

Office européen
des brevets

**RAPPORT DE RECHERCHE EUROPEENNE**

Numéro de la demande

EP 02 36 8067

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | EP 0 695 032 A (MATSUSHITA ELECTRIC IND CO LTD) 31 janvier 1996 (1996-01-31) * page 3, ligne 28 - page 5, ligne 55; figures 1-3 * | 1-4 | H03H17/06 |
| A | ADAMS R: "ASYNCHRONOUS CONVERSION THWARTS INCOMPATIBILITY IN SAMPLING A/D SYSTEMS" EDN ELECTRICAL DESIGN NEWS, CAHNERS PUBLISHING CO. NEWTON, MASSACHUSETTS, US, vol. 39, no. 15, 21 juillet 1994 (1994-07-21), pages 83-88, XP000491530 ISSN: 0012-7515 * le document en entier * | 1-4 | |

| | DOMAINES TECHNIQUES RECHERCHES (Int.Cl.7) |
|---|---|
| | H03H |

Le présent rapport a été établi pour toutes les revendications

| Lieu de la recherche | Date d'achèvement de la recherche | Examinateur |
|---|---|---|
| LA HAYE | 11 novembre 2002 | Coppieters, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**      EP 02 36 8067

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-11-2002

| Document brevet cité au rapport de recherche | Date de publication | Membre(s) de la famille de brevet(s) | Date de publication |
|---|---|---|---|
| EP 0695032    A | 31-01-1996 | EP   0695032 A1 | 31-01-1996 |
| | | DE   69428987 D1 | 13-12-2001 |
| | | DE   69428987 T2 | 04-04-2002 |
| | | JP   8046484 A | 16-02-1996 |
| | | US   5621404 A | 15-04-1997 |

EPO FORM P0460

Pour tout renseignement concernant cette annexe : voir Journal Officiel de l'Office européen des brevets, No.12/82